# EUROPÄISCHE PATENTSCHRIFT

(11) **EP 1 811 110 B1**
(45) Veröffentlichungstag und Bekanntmachung des Hinweises auf die Patenterteilung: **04.06.2008**
(21) Anmeldenummer: 06001399.2
(22) Anmeldetag: 24.01.2006
(51) Int. Cl.: E05C 19/06, H02G 3/14

(54) **Verriegelungseinheit**
Lock assembly
Dispositif de verrouillage

(43) Veröffentlichungstag der Anmeldung: 25.07.2007
(73) Patentinhaber: Delphi Technologies, Inc., Troy, MI 48007 (US)
(72) Erfinder: Koburg, Dirk, 42859 Remscheid (DE); Ackermann, Jörg, 58706 Menden (DE)
(74) Vertreter: Manitz, Finsterwald & Partner GbR

(56) Entgegenhaltungen:
- DE-A1- 3 346 243
- DE-A1- 3 932 722
- DE-A1- 19 642 517
- DE-U1- 8 422 129
- FR-A- 2 306 359
- US-A- 4 653 783
- US-A- 5 551 589
- US-A- 6 045 412
- "MULTIDIRECTIONAL LOCKING FEATURE FOR PLASTIC ENCLOSURE WITH ELECTROMAGNETIC CONTROL SEAL" IBM TECHNICAL DISCLOSURE BULLETIN, IBM CORP. NEW YORK, US, Bd. 37, Nr. 2A, 1. Februar 1994 (1994-02-01), Seiten 159-160, XP000432600 ISSN: 0018-8689

## Beschreibung

Die Erfindung betrifft eine Verriegelungseinheit mit einer Lasche und einem Laschengegenstück, die einen Rasthaken und ein Rasthakengegenstück aufweisen, die derart zusammenwirken, dass sie hintereinander greifen können und die Lasche und das Laschengegenstück gegen ein Auseinanderbewegen verriegeln können.

Derartige Verriegelungseinheiten werden zum Beispiel für die Verriegelung eines Deckels eines Behältnisses verwendet. Die Lasche kann zum Beispiel einen feststehenden Haken aufweisen, der mit einer Rampe versehen ist, während das Laschengegenstück einen beweglichen Verriegelungsarm umfasst, der ein Rastgegenstück aufweist, das mit dem feststehenden Haken nach Art eines Schnappverschlusses verrastet werden kann.

Es besteht die Gefahr, dass beim Schließen des Deckels der Verriegelungsarm und der feststehende Haken auf ihrer falschen Seite aufeinander treffen, so dass der Rasthaken von dem Rasthakengegenstück abgewandt ist und dementsprechend eine Verrastung nicht stattfindet. Dies ist insbesondere dann möglich, wenn die gegenseitige Lagerung des Deckels und des Behältnisses nicht präzise sondern zum Beispiel aufgrund der Verwendung von kostengünstigem und nicht zu festem Kunststoffmaterial eine gewisse Flexibilität aufweist.

In "Multi directional locking feature for plastic enclosure with electromagnetic control seal" IBM technical disclosure, IBM Corp. New York, U.S., Band 37, Nummer 2A, Februar 1994, Seiten 159 bis 160, ist eine Verriegelungseinheit gezeigt, bei welcher eine mit einem Rasthaken versehene Lasche mit einem Rasthakengegenstück eines Laschengegenstücks derart zusammenwirkt, dass die Lasche und das Laschengegenstück gegen ein Auseinanderbewegen verriegeln können.

DE 196 42 517 A1, US-A-6 045 412, FR-A-2 306 359, DE 84 22 129 U1, DE 39 32 722 A1, DE 33 46 243 A1 und US-A-5 551 589 beschreiben Verriegelungseinheiten, bei welchen eine mit einem Rasthaken versehene Lasche mit einem Rasthakengegenstück eines Laschengegenstücks derart zusammenwirkt, dass der Rasthaken und das Rasthakengegenstück hintereinander greifen können und die Lasche und das Laschengegenstück gegen ein Auseinanderbewegen verriegeln können. Die Lasche und/oder das Laschengegenstück sind an der Berührungsfläche, an der sie beim Verrastprozess aufeinandertreffen, derart angefast, dass die Berührungsflächen beim Aufeinandertreffen aneinander abgleiten.

Aus US-A-4 653 783 ist es zusätzlich bekannt, an einer solchen Lasche einen Vorsprung vorzusehen, der an ihrer der Berührungsfläche mit dem Laschengegenstück abgewandten Rückseite angeordnet ist.

Aufgabe der vorliegenden Erfindung ist es, eine Verriegelungseinheit anzugeben, bei der ein falsches Zusammenführen der Verriegelungselemente ausgeschlossen ist.

Diese Aufgabe wird mit einer Verriegelungseinheit mit den Merkmalen des Anspruchs 1 gelöst. Eine Baugruppe mit einer erfindungsgemäßen Verriegelungseinheit ist Gegenstand des Anspruchs 7 Unteransprüche sind auf bevorzugte Ausführungsformen gerichtet.

Eine erfindungsgemäße Verriegelungseinheit weist eine Lasche und ein Laschengegenstück auf, wobei entweder die Lasche einen Rasthaken und das Laschengegenstück ein Rasthakengegenstück, oder das Laschengegenstück einen Rasthaken und die Lasche ein Rasthakengegenstück aufweisen. Die Lasche und/oder das Laschengegenstück sind flexibel. Rasthaken und Rasthakengegenstück wirken derart zusammen, dass sie hintereinandergreifen können und die Lasche und das Laschengegenstück gegen ein Auseinanderbewegen verriegeln können. Die Lasche und/oder das Laschengegenstück ist an der Berührungsfläche, an der sie beim Verrastprozess aufeinandertreffen, derart angefast, dass die Berührungsflächen beim Aufeinandertreffen aneinander abgleiten, bis der Rasthaken und das Rasthakengegenstück zur Verriegelung hintereinander greifen. Die Lasche und das Laschengegenstück bzw. deren Rasthaken und Rasthakengegenstück wirken insofern wie ein Schnappverschluss.

Die erfindungsgemäße Verriegelungseinheit weist entweder eine Lasche auf, die an ihrer der Berührungsfläche mit dem Laschengegenstück abgewandten Rückseite einen von ihrer Rückseite weg weisenden Vorsprung aufweist, oder das Laschengegenstück weist an seiner der Berührungsfläche mit der Lasche abgewandten Rückseite einen von seiner Rückseite weg weisenden Vorsprung auf.

Der erfindungsgemäße Vorsprung verhindert ein fehlerhaftes Zusammenführen der Lasche und des Laschengegenstückes. Ist der Vorsprung an der Rückseite der Lasche vorgesehen, so verhindert er, dass das Laschengegenstrück beim Verriegeln auf der Rückseite der Lasche zu liegen kommt. Ist der Vorsprung an dem Laschengegenstück vorgesehen, so verhindert er, dass die Lasche beim Verriegeln auf der Rückseite des Laschengegenstückes zu liegen kommt. So ist sichergestellt, dass beim Zusammenführen der Lasche und des Laschengegenstückes der Rasthaken und das Rasthakengegenstück zusammenwirken können.

Insbesondere wird auf wirksame Weise ein Fehlstecken verhindert, wenn es zum Beispiel notwendig ist, die Verriegelung ohne optische Überwachung - also blind - oder automatisch durchzuführen.

Bei der erfindungsgemäßen Verriegelungseinheit ist ein Begrenzungselement vorgesehen, das dem Vorsprung gegenüber angeordnet ist. Insbesondere ist, wenn der Vorsprung an der Lasche vorgesehen ist, das Begrenzungselement ortsfest zu der Lasche und benachbart zu deren Rückseite angeordnet ist. Die Anordnung ist so gewählt, dass der in Verrastrichtung projizierte Abstand zwischen Vorsprung und Begrenzungselement so klein ist, dass es dem Laschengegenstück nicht möglich ist, in den Zwischenraum zwischen Vorsprung und Begrenzungselement einzutreten. Bei dieser Ausführungsform verhindert also das Begrenzungselement in Zusammenwirken mit dem Vorsprung, dass das Laschengegenstück auf der falschen Seite der Lasche zu liegen kommt.

Bei einer Ausführungsform, bei der der Vorsprung an dem Laschengegenstück vorgesehen ist, ist das Begrenzungselement derart ortsfest zu dem Laschengegenstück und benachbart zu dessen Rückseite angeordnet, dass der projizierte Abstand zwischen Vorsprung und Begrenzungselement so klein ist, dass es der Lasche nicht möglich ist, in den Zwischenraum zwischen Vorsprung und Begrenzungselement einzutreten. Hier verhindert das Begrenzungselement wirksam in Zusammenwirken mit dem Vorsprung, dass die Lasche beim Zusammenführen auf der falschen Seite des Laschengegenstückes zu liegen kommt.

Das Begrenzungselement verhindert außerdem bei Ausführungsformen, bei welchen der Vorsprung an dem Element (Lasche oder Laschengegenstück) angeordnet ist, das flexibel ist, dass das flexible Element beim Verrastprozess oder zum Beispiel beim Transport überdehnt wird.

Eine einfache Ausgestaltung des Begrenzungselementes ist dadurch gewährleistet, dass es als Wand ausgestaltet ist, die zu demjenigen Element (Lasche oder Laschengegenstück) parallel ist, an dem sich der Vorsprung befindet.

Besonders wirkungsvoll wirkt das Begrenzungselement, wenn der projizierte Abstand zwischen dem Vorsprung und dem Begrenzungselement gleich oder kleiner Null ist, das heißt insbesondere, wenn der Vorsprung das Begrenzungselement überragt.

Besonders leicht zusammenzuführen sind Lasche und Laschengegenstück, wenn der Vorsprung an der beim Verrastprozess vorauslaufenden Seite einen angefasten Bereich aufweist, an dem das jeweils andere Element beim Zusammenführen abgleiten kann.

Besonders effektiv ist das Zusammenwirken von Vorsprung und Begrenzungselement zur Verhinderung des falschen Zusammenführens von Lasche und Laschengegenstück, wenn das in Verrastrichtung dem Vorsprung zugewandte Ende des Begrenzungselementes und das in Verrastrichtung dem Begrenzungselement zugewandte Ende des Vorsprungs im Wesentlichen bündig zueinander sind, so dass sie sich gerade noch übereinander bewegen können, ohne sich zu behindern.

Bei entsprechender Dimensionierung des Rasthakens und der daraus resultierenden Ausweichbewegung des Vorsprunges kann das Begrenzungselement auch eine Höhe haben, dass der Vorsprung nicht über das Begrenzungselement bewegt werden kann. Ein fehlerhaftes Zusammenführen von Lasche und Laschengegenstück ist dann ebenfalls wirksam verhindert. Insbesondere kann das Begrenzungselement auch höher sein als der Vorsprung.

Das Laschengegenstück kann zum Beispiel einen Bügel umfassen. Besonders stabil ist eine Ausführungsform, bei der das Laschengegenstück Teil einer Rastöffnung ist, die beim Zusammenführen des Laschengegenstückes und der Lasche die Lasche aufnimmt.

Das Rasthakengegenstück kann zum Beispiel einen zweiten Rasthaken umfassen. Eine einfache Ausgestaltung sieht vor, dass das Rasthakengegenstück eine Rastöse umfasst, in die der Rasthaken der erfindungsgemäßen Verriegelungseinheit eingreifen kann.

Die erfindungsgemäße Verriegelungseinheit kann überall dort vorteilhaft eingesetzt werden, bei denen zwei Elemente durch einen Schnappprozess miteinander verriegelt bzw. verbunden werden sollen.

Die Erfindung betrifft weiterhin eine Baugruppe mit einem Korpus und einer diesen abdeckenden Abdeckung. Insbesondere kann der Korpus zum Beispiel ein Behältnis umfassen, das mit einer Klappe, insbesondere einem Deckel, zu verschließen ist. Zur Verriegelung der Abdeckung an dem Korpus ist bei der erfindungsgemäßen Baugruppe eine erfindungsgemäße Verriegelungseinheit vorgesehen. Besonders geeignet ist die erfindungsgemäße Verriegelungseinheit für den automobilen Bereich, z.B. für Sicherungsdosen.

Die erfindungsgemäße Baugruppe mit einem Korpus und einer Abdeckung ist jedoch nicht auf Behältnisse beschränkt, sondern kann zum Beispiel auch Verblendungen oder ähnliches umfassen, bei denen eine Abdeckung auf einem anderen Element zu befestigen ist. Der Begriff Korpus beschreibt insofern nicht notwendigerweise einen Hohlkörper, sondern das Gegenstück zu der Abdeckung.

Die Erfindung wird anhand der beiliegenden Figuren im Detail erläutert, die eine Ausführungsform einer erfindungsgemäßen Verriegelungseinheit bzw. eine Ausführungsform einer erfindungsgemäßen Baugruppe darstellen. Dabei zeigt
- Fig. 1: ein Detail einer erfindungsgemäßen Baugruppe, die eine Ausführungsform einer erfindungsgemäßen Verriegelungseinheit umfasst,
- Fig. 2: ein Detail dieser Baugruppe,
- Fig. 3: eine andere Ansicht dieses Details,
- Fig. 4: eine perspektivische Teilschnittansicht der Baugruppe der Fig. 1, und
- Fig. 5: einen seitlichen Teilschnitt durch eine erfindungsgemäße Verriegelungseinheit.

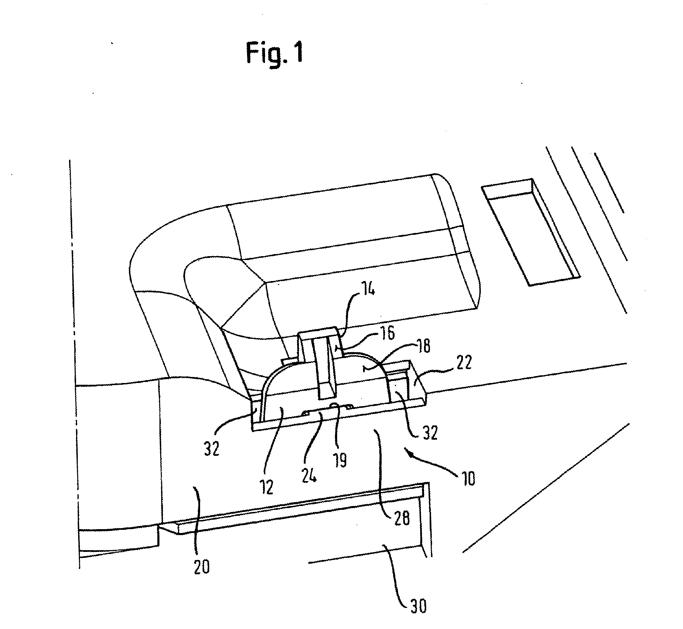

Fig. 1 zeigt eine erfindungsgemäße Baugruppe, die in dem gezeigten Fall aus einem Deckel 20 besteht, der einen Korpus 30 verschließt, wobei Deckel und Korpus nur als Ausschnitt gezeigt sind. Bei dem Korpus 30 kann es sich zum Beispiel um eine Sicherungsdose in einem Automobil handeln.

Die Verriegelungseinheit 10 umfasst eine Lasche 12, die an dem Korpus 30 befestigt ist und ausreichend flexibel ist, dass sie um einen kleinen Winkelbetrag in der gewählten Darstellung der Fig. 1 nach hinten verschwenkbar ist. Der Korpus 30, der Deckel 20 und die Lasche 12 können zum Beispiel aus Kunststoff bestehen.

Fig. 1 zeigt den verschlossenen Zustand, in dem die Lasche 12 durch eine Rastöffnung 22 im Deckel 20 hindurchgetreten ist.

Die äußere Wand 28 der Rastöffnung 22 stellt ein Laschengegenstück dar, an dem sich ein nach hinten weisender Rasthaken 24 befindet. Er greift in die Rastöse 19 in der Lasche 12 ein und verhindert so eine Bewegung des Deckels 20 nach oben.

Die Lasche 12 weist im oberen Bereich einen angefasten Bereich 18 auf, der beim Zusammenführen des Deckels 20 und des Korpus 30 mit einem in Fig. 1 nicht sichtbaren angefasten Gegenstück der äußeren Wand 28 des Deckels 20 bzw. mit einem angefasten Bereich an der Unterseite des Rasthakens 24 zusammenwirkt um ein Abgleiten der Lasche 12 an der äußeren Wand 28 und dem Rasthaken 24 zu ermöglichen, wenn der Deckel 20 auf den Korpus 30 aufgesetzt wird.

Bezugsziffer 14 bezeichnet einen in der Fig. 1 nach hinten weisenden Vorsprung an der Lasche 12 mit einem ebenfalls angefasten Bereich 16.

Durch die Rastöffnung 22 hindurch ist die Begrenzungswand 32 erkennbar, die weiter unten näher erläutert wird.

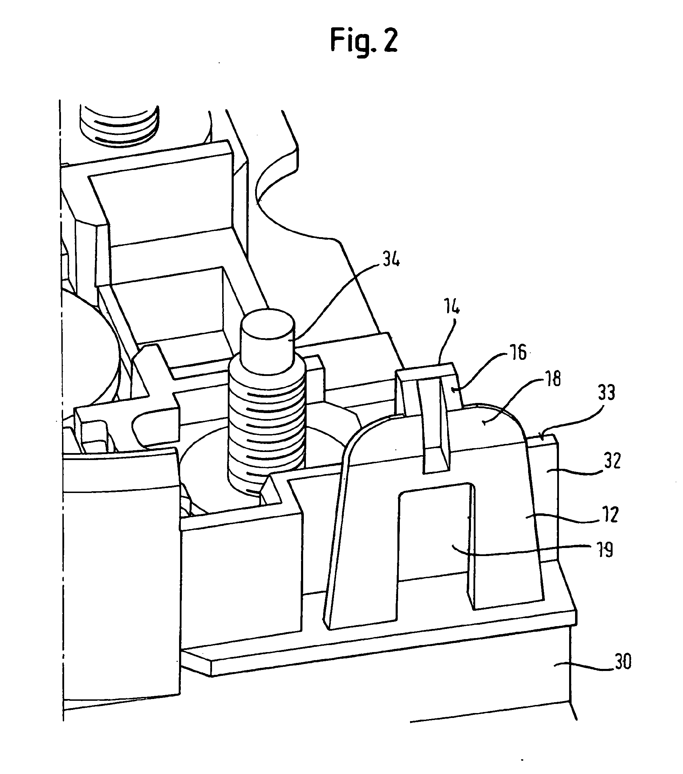

Fig. 2 zeigt isoliert den Korpus 30 mit der Lasche 12. Die obere Seite der Begrenzungswand 32 ist mit Bezugsziffer 33 benannt.

In dem Korpus 30 ist ein Schraubbolzen 34 zum Beispiel für einen Ringkabelschuh angeordnet.

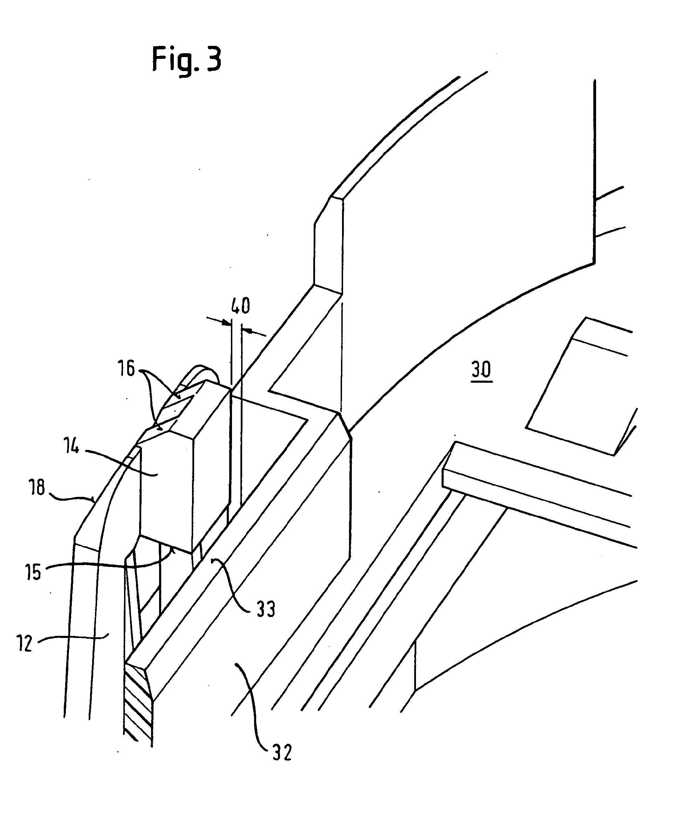

Fig. 3 zeigt den Korpus 30 mit der Lasche 12 in anderer Ansicht. Hier ist erkennbar, dass die Unterseite 15 des Vorsprungs 14 und die Oberseite 33 der Begrenzungswand 32 nahezu in gleicher Höhe angeordnet sind. Der projizierte Abstand 40 zwischen der Rückseite des Vorsprungs 14 und der Begrenzungswand 32 ist so gering gewählt, dass er kleiner als die Dicke der äußeren Wand 28 des Deckels 20 ist.

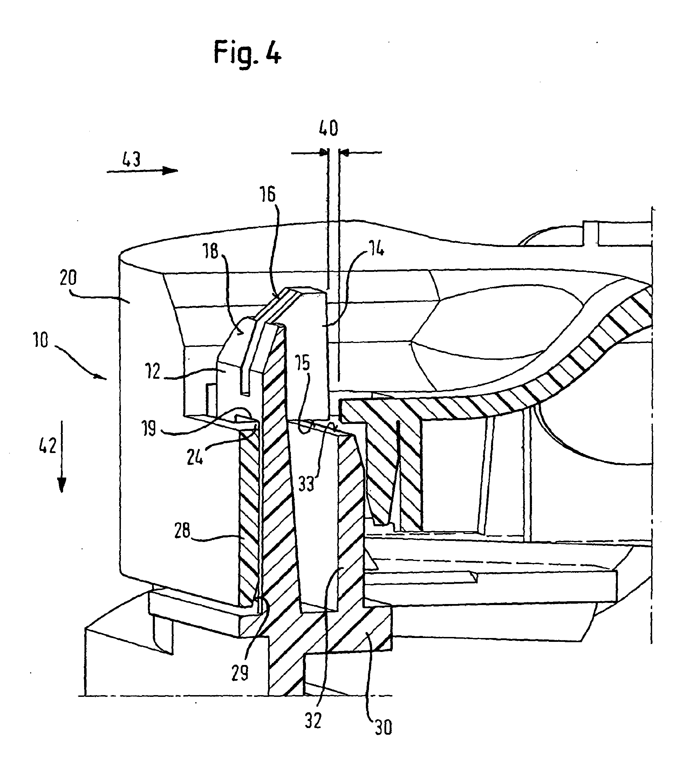

Fig. 4 zeigt einen perspektivischen Teilschnitt der Anordnung der Fig. 1, in der der angefaste Bereich 29 der äußeren Wand 28 erkennbar ist, die das Laschengegenstück darstellt. Pfeil 42 zeigt die Richtung an, in der der Deckel 20 bewegt wird, um ihn mit dem Korpus 30 zu verriegeln. Je nach Ausgestaltung wird der Deckel 20 dazu geklappt oder aufgesteckt. Pfeil 42 stellt also die Verrastrichtung bzw. die Verriegelungsrichtung dar.

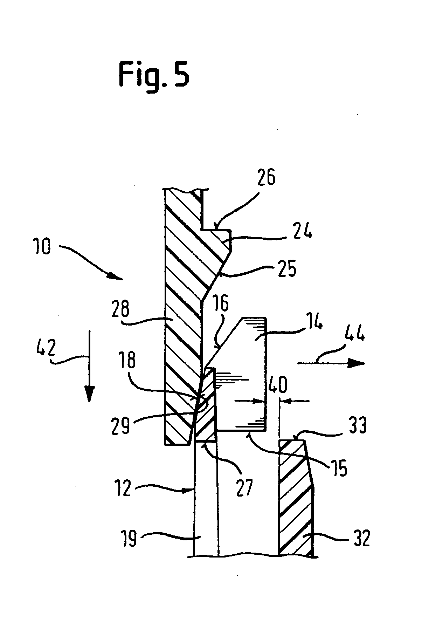

In Fig. 5 ist ein seitlicher Schnitt durch die Verriegelungseinheit 10 im Bereich der Rastöse 19 bzw. des Vorsprunges 14 gezeigt.

In dieser Schnittdarstellung ist insbesondere auch der angefaste Bereich 25 des Rasthakens 24 erkennbar. Im verrasteten Zustand wird die Oberfläche 26 des Rasthakens hinter die Fläche 27 der Rastöse eingerastet sein. Der Pfeil 44 gibt die Ausweichrichtung der in diesem Beispiel flexiblen Lasche 12 mit dem Vorsprung 14 an.

Die erfindungsgemäße Baugruppe, die Gegenstand der Fig. 1 bis 5 ist, wird wie folgt eingesetzt. Zum Verschließen wird der Deckel 20 je nach Ausgestaltung in Richtung des Pfeils 42 entweder aufgesteckt oder geklappt. Der angefaste Bereich 29 der äußeren Wand 28 des Deckels 20 wirkt mit dem angefasten Bereich 18 der Lasche 12 zusammen, so dass die Lasche 12 in Richtung 44 ausweicht (Fig. 5). Im weiteren Verlauf kommt die ebenfalls angefaste Unterseite 25 des Rasthakens 24 mit dem angefasten Bereich 18 in Berührung, so dass die Lasche 12 noch weiter nach hinten ausweicht. Schließlich erreicht der Rasthaken 24 die Rastöse 19 und tritt in diese ein. Die Lasche 12 bewegt sich wieder nach vorne in Richtung der äußeren Wand 28 des Deckels 20, so dass der Rasthaken 24 in der Rastöse 19 zu liegen kommt. Die Oberseite 26 des Rasthakens 24 tritt hinter die Fläche 27 der Rastöse 19, so dass ein Entfernen des Deckels 20 entgegen der Verrastrichtung 42 nicht mehr möglich ist. Auf diese Weise ist ein sicherer Verschluss des Deckels 20 an dem Korpus 30 gewährleistet.

Selbstverständlich können an einer Baugruppe mehrere derartige Verriegelungseinheiten vorgesehen sein.

Beim Aufsetzen bzw. Zuklappen des Deckels 20 kann es zum Beispiel aufgrund der Flexibilität von Klappscharnieren oder ungenauem Aufsetzen zu Versetzungen des Deckels 20 zum Beispiel in Richtung des Pfeils 43 kommen. Trotzdem ist bei der erfindungsgemäßen Baugruppe gewährleistet, dass ein korrekter Verschluss stattfindet. Auch wenn der angefaste Bereich 29 so weit in Richtung des Pfeils 43 versetzt ist, dass er nicht mit dem angefasten Bereich 18 der Lasche 12 in Kontakt kommt, wird er durch den angefasten Bereich 16 des Vorsprungs 14 in die korrekte Position gebracht und der Deckel 20 so zentriert.

Der Vorsprung 14 verhindert auf wirksame Weise, dass die als Laschengegenstück wirkende äußere Wand 28 des Deckels 20 auf der falschen Seite, also hinter die Lasche 12 geraten kann, wodurch der Rasthaken 24 nicht in verriegelnder Weise mit der Rastöse 19 zusammenwirken könnte. Dazu ist der Abstand 40 der Rückseite des Vorsprungs 14 von der Begrenzungswand 32 so klein, dass die äußere Wand 28 des Deckels 20 nicht dazwischen passt.

Insbesondere im automobilen Bereich ist es oftmals notwendig, einzelne Elemente, zum Beispiel den Deckel und den Korpus, ohne gleichzeitige optische Überwachung - also blind - oder automatisch zu verriegeln. Die erfindungsgemäße Verriegelungseinheit bietet hier eine sichere Lösung, die ein Fehlstecken wirksam verhindert.

Durch die Begrenzungswand 32 ist außerdem gewährleistet, dass die Lasche 12 zum Beispiel beim Transport oder beim Aufstecken des Deckels 20 nicht überdehnt werden kann.

Bei einer nicht gezeigten Ausführungsform ist die Begrenzungswand 32 so hoch gewählt, dass ihre Oberseite 33 höher als der Vorsprung 14 an der Lasche 12 oder zumindest höher als dessen Unterseite 15 ist, wobei der Rasthaken 24 in seinen Dimensionen derart gewählt ist, dass die Lasche 12 trotz der durch die Begrenzungswand 32 bewirkten Einschränkung der seitlichen Laschenausweichbewegung weit genug ausweichen kann, dass der Rasthaken an der Lasche 12 abgleiten kann, bis er in die Rastöffnung 19 eintritt.

Bei einer anderen nicht gezeigten Ausführungsform ist die in Fig. 5 mit 26 bezeichnete Oberfläche des Rasthakens 24 ebenfalls (zum Beispiel in einem Winkel von 45 bis 60 Grad) angefast. Bei einer solchen Ausführungsform ist das Entriegeln erleichtert. Die dann schräge Fläche, die der Fläche 26 in Fig. 5 entspricht, gleitet bei Ausüben einer ausreichenden Entriegelungskraft entgegen dem Pfeil 42 an der Fläche 27 der Rastöse 19 ab und bewegt die Lasche 12 in Richtung des Pfeiles 44. Durch geeignete Auswahl des Winkels der angefasten Fläche, die der Fläche 26 in Fig. 5 entspricht, kann die Entriegelungskraft gewählt werden. Derselbe Effekt lässt sich erreichen, indem die in Fig. 5 mit 27 bezeichnete Fläche der Rastöse 19 anstelle der in Fig. 5 mit 26 bezeichneten Fläche oder zusätzlich zu der in Fig. 5 mit 26 bezeichneten Fläche angefast ist.

Bei einer solchen Ausführungsform, bei der entweder die in Fig. 5 mit 26 bezeichnete Oberfläche und/oder die in Fig. 5 mit 27 bezeichnete Fläche angefast ist, entsteht zusätzlich ein selbst verstärkender Rastmechanismus. Sobald bei einer solchen Ausführungsform der Rasthaken 24 in die Rastöse 19 eingetreten ist, wird der Rasthaken 24 durch die bei dieser nicht gezeigten Ausführungsform angefasten Oberflächen, die den Flächen 26 und 27 in Fig. 5 entsprechen, weiter in Richtung des Pfeiles 42 bewegt, wenn die Winkel der Fasen entsprechend ausgewählt sind.

Begriffe wie "oben" und "unten" werden in dem vorliegenden Text nur zur Identifizierung der einzelnen Ausrichtungen gemäß der in den Figuren gewählten Darstellung verwendet. Es soll dadurch nicht ausgedrückt werden, dass zum Beispiel die Lasche 12 nicht auch nach unten oder seitlich weisen kann, wobei der Deckel 20 dann von unten bzw. von der Seite angeklappt wird.

### Bezugszeichenliste

- 10: Verriegelungseinheit
- 12: Lasche
- 14: Vorsprung
- 15: Unterseite des Vorsprungs
- 16: angefaster Bereich des Vorsprungs
- 18: angefaste Berührungsfläche der Lasche
- 19: Rastöse der Lasche
- 20: Deckel
- 22: Rastöffnung im Deckel
- 24: Rasthaken
- 25: angefaster Bereich des Rasthakens
- 26: Oberseite des Rasthakens
- 27: oberes Ende der Rastöse
- 28: Deckelwand, Laschengegenstück
- 29: angefaste Berührungsfläche der Deckelwand
- 30: Korpus
- 32: Begrenzungswand
- 33: Oberseite der Begrenzungswand
- 34: Schraubbolzen
- 40: projizierter Abstand zwischen Vorsprung und Begrenzungswand
- 42: Verrastrichtung
- 43: mögliche Deckelversetzungsrichtung
- 44: Ausweichrichtung der Lasche

## Patentansprüche

1. Verriegelungseinheit (10) mit einer Lasche (12) und einem Laschengegenstück (28), wobei
- die Lasche (12) und/oder das Laschengegenstück flexibel ist,
- entweder die Lasche einen Rasthaken und das Laschengegenstück ein Rasthakengegenstück, oder das Laschengegenstück (28) einen Rasthaken (24) und die Lasche (12) ein Rasthakengegenstück (19) aufweisen,
- der Rasthaken (24) und das Rasthakengegenstück (19) derart zusammenwirken, dass sie hintereinander greifen können und die Lasche (12) und das Laschengegenstück (28) gegen ein Auseinanderbewegen verriegeln können,
- die Lasche (12) und/oder das Laschengegenstück (28) an der Berührungsfläche (18, 29), an der sie beim Verrastprozess aufeinander treffen, derart angefast ist, dass die Berührungsflächen (18, 29) beim Aufeinandertreffen aneinander abgleiten bis der Rasthaken (24) und das Rasthakengegenstück (19) zur Verriegelung hintereinander greifen,
und wobei
(i) die Lasche (12) an ihrer der Berührungsfläche (18) mit dem Laschengegenstück (28), abgewandten Rückseite einen von ihrer Rückseite weg weisenden Vorsprung (14) aufweist, oder
(ii) das Laschengegenstück (28) an seiner der Berührungsfläche (29) mit der Lasche (12) abgewandten Rückseite einen von seiner Rückseite weg weisenden Vorsprung aufweist,
und wobei die Verriegelungseinheit ein Begrenzungselement (32) aufweist, das
(i1) - wenn der Vorsprung (14) an der Lasche (12) vorgesehen ist - derart ortsfest zu der Lasche (12) und benachbart zu deren Rückseite, an der sich der Vorsprung (14) befindet, angeordnet ist, dass der in Verrastrichtung (42) projizierte Abstand (40) zwischen Vorsprung (14) und Begrenzungselement (32) so klein ist, dass es dem Laschengegenstück (28) nicht möglich ist, in den Zwischenraum zwischen Vorsprung (14) und Begrenzungselement (32) einzutreten, wobei es sich bei dem Begrenzungselement um eine zur Lasche (12) im Wesentlichen parallele Wand (32) handelt, oder
(ii1) - wenn der Vorsprung an dem Laschengegenstück vorgesehen ist - derart ortsfest zu dem Laschengegenstück und benachbart zu dessen Rückseite, an der sich der Vorsprung befindet, angeordnet ist, dass der in Verrastrichtung projizierte Abstand zwischen Vorsprung und Begrenzungselement so klein ist, dass es der Lasche nicht möglich ist, in den Zwischenraum zwischen Vorsprung und Begrenzungselement einzutreten, wobei es sich bei dem Begrenzungselement um eine zum Laschengegenstück im wesentlichen parallele Wand handelt.

2. Verriegelungseinheit nach Anspruch 1, bei der der in Verrastrichtung (42) projizierte Abstand (40) zwischen dem Vorsprung (14) und dem Begrenzungselement (32) kleiner oder gleich Null ist.

3. Verriegelungseinheit nach einem der Ansprüche 1 oder 2, bei der das in Verrastungsrichtung dem Vorsprung (14) zugewandte Ende (33) des Begrenzungselementes (32) im wesentlichen bündig mit dem in Verrastungsrichtung dem Begrenzungselement (32) zugewandten Ende (15) des Vorsprunges (14) ist.

4. Verriegelungseinheit nach einem der Ansprüche 1 bis 3, bei der der Vorsprung (14) einen angefasten Bereich (16) an der beim Verrastprozess vorauslaufenden Seite aufweist.

5. Verriegelungseinheit nach einem der Ansprüche 1 bis 4, bei der das Laschengegenstück (28) Teil einer Rastöffnung (22) ist, die beim Verrasten die Lasche (12) aufnimmt.

6. Verriegelungseinheit nach einem der Ansprüche 1 bis 5, bei der das Rasthakengegenstück eine Rastöse (19) umfasst, in die der Rasthaken (24) beim Verrasten eingreift.

7. Baugruppe, insbesondere Behältnis, mit einem Korpus (30) und einer diesen abdeckenden Abdeckung (20), insbesondere einem Deckel, mit wenigstens einer Verriegelungseinheit (10) nach einem der Ansprüche 1 bis 6 zum Verriegeln der Abdeckung (20) an dem Korpus (30).

8. Baugruppe nach Anspruch 7, bei dem sich die Lasche (12) an dem Korpus (30) und das Laschengegenstück (28) an der Abdeckung (20) befinden.

## Claims

1. A latching unit 10) comprising a lug (12) and a lug mating piece (28), wherein
- the lug (12) and/or the lug mating piece is/are flexible;
- either the lug has a latch hook and the lug mating piece has a latch hook mating piece or the lug mating piece (28) has a latch hook (24) and the lug (12) has a latch hook mating piece (19);
- the latch hook (24) and the latch hook mating piece (19) cooperate such that they can engage behind one another and can latch the lug (12) and the lug mating piece (28) against a movement apart from one another;
- the lug (12) and/or the lug mating piece (28) is/are chamfered at the contact surface (18, 29) at which they meet one another in the latching process such that the contact surfaces (18, 29) slide off one another when they meet one another until the latch hook (24) and the latch hook mating piece (19) engage behind one another for the latching;
and wherein
(i) the lug (12) has a projection (14) facing away from its rear side at its rear side remote from the contact surface (18) with the lug mating piece (28); or
(ii) the lug mating piece (28) has a projection facing away from its rear side at its rear side remote from the contact surface (29) with the lug (12),
and wherein the latching unit has a boundary element (32) which
(i1) - when the projection (14) is provided at the lug (12) - is arranged at a fixed position to the lug (12) and adjacent to its rear side at which the projection (14) is located, such that the spacing (40) projected in the latch direction (42) between the projection (14) and the boundary element (32) is so small that it is not possible for the lug mating piece (28) to enter into the intermediate space between the projection (14) and the boundary element (32), with the boundary element being a wall (32) substantially parallel to the lug (12); or
(iiL) - when the projection is provided at the lug mating piece - is arranged at a fixed position to the lug mating piece and adjacent to its rear side at which the projection is located, such that the spacing projected in the latch direction between the projection and the boundary element is so small that it is not possible for the lug to enter into the intermediate space between the projection and the boundary element), with the boundary element being a wall substantially parallel to the lug mating piece.

2. A latching unit in accordance with claim 1, wherein the spacing (40) projected in the latch direction (42) between the projection (14) and the boundary element (32) is smaller than or equal to zero.

3. A latching unit in accordance with one of the claims 1 or 2, wherein the end (33) of the boundary element (32) facing the projection (14) in the latch direction substantially coincides with the end (15) of the projection (14) facing the boundary element (32) in the latch direction.

4. A latching unit in accordance with any one of the claims 1 to 3, wherein the projection (14) has a chamfered region (16) at the side running ahead in the latch process.

5. A latching unit in accordance with any one of the claims 1 to 4, wherein the lug mating piece (28) is part of a latch opening (22) which receives the lug (12) on the latching.

6. A latching unit in accordance with any one of the claims 1 to 5, wherein the latch hook mating piece comprises a latch eye (19) into which the latch hook (24) engages on the latching.

7. An assembly, in particular a container, comprising a body (30) and a cover (20) covering it, in particular a lid, comprising at least one latching unit (10) in accordance with any one of the claims 1 to 6 for the latching of the cover (20) to the body (30).

8. An assembly in accordance with claim 7, wherein the lug (12) is located at the body (30) and the lug mating piece (28) is located at the cover (20).

## Revendications

1. Unité de verrouillage (10) avec une éclisse (12) et une contre-pièce d'éclisse (28), dans laquelle
- l'éclisse (12) et/ou la contre-pièce d'éclisse est flexible,
- soit l'éclisse comporte un crochet d'encliquetage et la contre-pièce d'éclisse une contre-pièce de crochet d'encliquetage, soit la contre-pièce d'éclisse (28) comporte un crochet d'encliquetage (24) et l'éclisse (12) une contre-pièce de crochet d'encliquetage (19),
- le crochet d'encliquetage (24) et la contre-pièce de crochet d'encliquetage (19) coopèrent de manière à pouvoir passer l'une derrière l'autre et à pouvoir verrouiller l'éclisse (12) et la contre-pièce d'éclisse (28) contre un mouvement d'écartement,
- l'éclisse (12) et/ou la contre-pièce d'éclisse (28) sont chanfreinées sur la surface de contact (18, 29), sur laquelle elles parviennent lors du processus d'encliquetage, de manière que lors de l'impact les surfaces de contact (18, 29) glissent l'une sur l'autre jusqu'à ce que le crochet d'encliquetage (24) et la contre-pièce de crochet d'encliquetage (19) passent l'un derrière l'autre pour le verrouillage,
et dans laquelle
(i) l'éclisse (12) présente, sur sa face arrière tournée à l'opposé de la surface de contact (18) avec la contre-pièce d'éclisse (28), une saillie (14) partant de sa face arrière,
ou
(ii) la contre-pièce d'éclisse (28) présente, sur sa face arrière tournée à l'opposé de la surface de contact (29) avec l'éclisse (12), une saillie partant de sa face arrière,
et dans laquelle l'unité de verrouillage comporte un élément de limitation (32) qui
(i1) - si la saillie (14) est prévue sur l'éclisse (12) - est disposé de manière fixe par rapport à l'éclisse (12) et au voisinage de sa face arrière, sur laquelle se trouve la saillie (14), de manière que la distance (40), projetée dans la direction d'encliquetage (42), entre la saillie (14) et l'élément de limitation (32), soit suffisamment petite pour ne pas permettre à la contre-pièce d'éclisse (28) d'entrer dans l'interstice entre la saillie (14) et l'élément de limitation (32), l'élément de limitation étant une paroi (32) sensiblement parallèle à l'éclisse (12), ou
(ii1) - si la saillie est prévue sur la contre-pièce d'éclisse - est disposé de manière fixe par rapport à la contre-pièce d'éclisse et au voisinage de sa face arrière, sur laquelle se trouve la saillie, de manière que la distance, projetée dans la direction d'encliquetage, entre la saillie et l'élément de limitation, soit suffisamment petite pour ne pas permettre à l'éclisse d'entrer dans l'interstice entre la saillie et l'élément de limitation, l'élément de limitation étant une paroi sensiblement parallèle à la contre-pièce d'éclisse.

2. Unité de verrouillage selon la revendication 1, dans laquelle la distance (40), projetée dans la direction d'encliquetage (42), entre la saillie (14) et l'élément de limitation (32), est inférieure ou égale à zéro.

3. Unité de verrouillage selon l'une quelconque des revendications 1 ou 2, dans laquelle l'extrémité (33), tournée vers la saillie (14) dans la direction d'encliquetage, de l'élément de limitation (32), est sensiblement à fleur de l'extrémité (15), tournée vers l'élément de limitation (32) dans la direction d'encliquetage, de la saillie (14).

4. Unité de verrouillage selon l'une quelconque des revendications 1 à 3, dans laquelle la saillie (14) présente une zone chanfreinée (16) sur le côté venant en premier lors du processus d'encliquetage.

5. Unité de verrouillage selon l'une quelconque des revendications 1 à 4, dans laquelle la contre-pièce d'éclisse (28) fait partie d'une ouverture d'encliquetage (22) qui reçoit l'éclisse (12) lors de l'encliquetage.

6. Unité de verrouillage selon l'une quelconque des revendications 1 à 5, dans laquelle la contre-pièce de crochet d'encliquetage comprend un oeillet d'encliquetage (19) dans lequel s'engage le crochet d'encliquetage (24) lors de l'encliquetage.

7. Ensemble, en particulier récipient, avec un corps (30) et un capot (20) recouvrant celui-ci, en particulier un couvercle, avec au moins une unité de verrouillage (10) selon l'une quelconque des revendications 1 à 6 pour verrouiller le capot (20) sur le corps (30).

8. Ensemble selon la revendication 7 dans lequel l'éclisse (12) se trouve sur le corps (30) et la contre-pièce d'éclisse (28) sur le capot (20).
